# EUROPÄISCHE PATENTSCHRIFT

(11) **EP 2 714 805 B1**
(45) Veröffentlichungstag und Bekanntmachung des Hinweises auf die Patenterteilung: **08.07.2015**
(21) Anmeldenummer: 12720106.9
(22) Anmeldetag: 03.05.2012
(51) Int. Cl.: C08L 77/00, E04D 3/32, H01L 31/048

(54) **PHOTOVOLTAIK-SYSTEM ZUR INSTALLATION AUF DÄCHERN MIT KUNSTSTOFFTRÄGER UND PHOTOVOLTAIK-MODUL**
PHOTOVOLTAIC SYSTEM FOR INSTALLATION ON ROOFS COMPRISING A PLASTIC CARRIER AND PHOTOVOLTAIC MODULE
SYSTÈME PHOTOVOLTAÏQUE POUR UNE INSTALLATION SUR DES TOITS, COMPRENANT UN SUPPORT PLASTIQUE ET UN MODULE PHOTOVOLTAÏQUE

(30) Priorität: 03.06.2011 DE 102011104303
(43) Veröffentlichungstag der Anmeldung: 09.04.2014
(73) Patentinhaber: BASF SE, 67056 Ludwigshafen (DE)
(72) Erfinder: HERWIG, Peter, 63743 Aschaffenburg (DE); MULLER, Nicolas, F-57530 Courcelle-Chaussy (FR); FLECKENSTEIN, Stefan, 63879 Weibersbrunn (DE); SCHÄFER, Andre, 67346 Speyer (DE); PRINZ, Michael, 67147 Forst (DE); MÄGERLEIN, Andreas, 67061 Ludwigshafen (DE); DIETRICH, Matthias, 69469 Weinheim (DE)
(74) Vertreter: Blumbach Zinngrebe
(86) Internationale Anmeldenummer: PCT/EP2012/001896
(87) Internationale Veröffentlichungsnummer: WO 2012/163457

(56) Entgegenhaltungen:
- EP-A1- 0 029 180
- EP-A1- 1 833 098
- DE-A1-102004 015 305
- DE-C1- 19 840 544
- JP-A- 2000 204 717

## Beschreibung

Die Erfindung betrifft Photovoltaik-Anlagen im Allgemeinen. Im Speziellen betrifft die Erfindung ein System zur Installation von Photovoltaik-Anlagen auf Dächern.

Aus dem Stand der Technik sind eine Vielzahl von Halterungen zur Montage von Photovoltaik-Modulen auf Hausdächern bekannt. Eine gattungsgemässe Halterung, die den Oberbegriff des Anspruchs 1 offenbart, ist aus der EP 1 833 098 bekannt.

Bei den bisherigen Befestigungssystemen werden die Photovoltaik-Module vielfach mit Verschraubungsklemmen an der Halterung befestigt. Das Verschrauben ist dabei vergleichsweise zeitaufwändig. Auch sind bei üblichen Halterungen im Allgemeinen eine Vielzahl von Einzelteilen, unter anderem die vorstehend genannten Verschraubungsklemmen für die Montage erforderlich.

Die Montage stellt sich entsprechend aufwändig dar. Dies führt dazu, dass die Montagekosten einen nicht vernachlässigbaren Anteil an den Investitionskosten für eine Photovoltaik-Anlage ausmachen. So kann man auch bei Großprojekten derzeit mit mehr als 15% Anteil der Montagekosten an der Gesamt-Investitionssumme rechnen. Hierbei fällt zusätzlich ins Gewicht, dass dieser Anteil bei sinkenden Modulpreisen auch noch steigt.

Ein weiterer Nachteil bisheriger, auf Dächern installierter Photovoltaik-Anlagen ist das durch die Halterung entstehende zusätzliche Gewicht. Unter Umständen kann damit das Gesamtgewicht der Anlage so groß werden, dass die zulässige Gesamtlast der Dachkonstruktion überschritten wird. In diesem Fall müsste dann die Dachkonstruktion verstärkt werden.

Der Erfindung liegt daher die Aufgabe zugrunde, eine schnell und einfach zu montierende und dabei auch leichte Photovoltaik-Anlage bereitzustellen. Diese Aufgabe wird durch den Gegenstand der unabhängigen Ansprüche gelöst. Vorteilhafte Ausführungsformen und Weiterbildungen der Erfindung sind in den jeweiligen abhängigen Ansprüchen angegeben.

Erfindungsgemäß wird ein dachintegriertes Photovoltaik-System mit Kunststoff-Trägern vorgeschlagen.

Bei dem dachintegrierten Photovoltaik-System mit Kunststoff-Trägern handelt es sich um eine optimierte Lösung insbesondere für große Photovoltaik-Anlagen. Weiterhin ist die Erfindung auch besonders für eine begleitende Dachsanierung, wie etwa von Faserzement-Dächern geeignet, wenn im Zuge der Dachsanierung die Dacheindeckung ausgetauscht wird.

Das erfindungsgemäße Photovoltaik-System ist im Wesentlichen zweiteilig. Ein Teil bildet ein Kunststoff-Träger, der andere Teil ist das Photovoltaik-Modul. der Kunststoff-Träger kann direkt auf einer Dachunterkonstruktion befestigt werden, so dass eine zusätzliche Dacheindeckung entfallen kann. Auf diese Weise wird der gesamte, die Dachunterkonstruktion belastende Dachaufbau erheblich leichter. Einen zusätzlichen Beitrag leistet dabei der Kunststoff-Träger, der aufgrund des Materials im Allgemeinen entsprechend leichter ist, als etwa Metallträger entsprechender Abmessungen.

Weiterhin zeichnet sich die Erfindung dadurch aus, dass die Photovoltaik-Module verschraubungsfrei, im Speziellen mittels eines Rast- oder Bajonett-Verschlusses auf dem Kunststoff-Träger befestigbar sind. Nachdem die Kunststoff-Träger also auf dem Dach befestigt sind, können die Photovoltaik-Module werkzeugfrei durch einen Rastmechanismus am jeweiligen Kunststoff-Träger befestigt werden.

Die Erfindung wird nachfolgend anhand von Ausführungsbeispielen und unter Bezugnahme auf die beigeschlossenen Zeichnungen näher erläutert. Dabei verweisen gleiche Bezugszeichen in den Zeichnungen auf gleiche oder entsprechende Elemente. Es zeigen:
- Fig. 1: eine Ansicht des Kunststoff-Trägers,
- Fig. 2: mehrere gestapelte Kunststoff-Träger,
- Fig. 3: eine Ansicht eines Photovoltaik-Moduls,
- Fig. 4: ausgehend von den in Fig. 1 und 3 gezeigten Elementen anhand einer vergrößerten Ansicht einen ersten Verfahrensschritt zur Fixierung eines Photovoltaik-Moduls auf dem Kunststoff-Träger 1,
- Fig. 5: einen Ausschnitt eines Photovoltaik-Installationssystems mit auf dem Kunststoff-Träger verrastetem Photovoltaik-Modul.

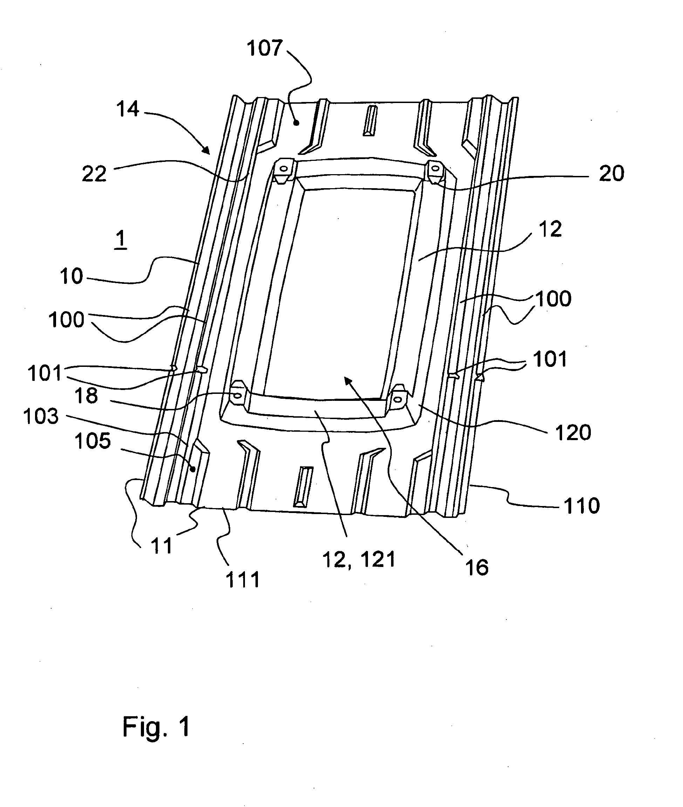

In Fig. 1 ist eine Ansicht auf die Oberseite 14 eines Kunststoff-Trägers 1, nachfolgend auch als Wanne bezeichnet, für ein daran zu befestigendes Photovoltaik-Modul gezeigt. Als Oberseite 14 wird dabei im Sinne der Erfindung diejenige Seite des Kunststoff-Trägers 1 bezeichnet, auf welcher das Photovoltaik-Modul befestigt wird und welche beim Einbau in eine Dachfläche nach oben weist. Der erfindungsgemäße Kunststoff-Träger 1, wie er als Beispiel in Fig. 1 gezeigt ist, ist als einteiliges ausgeformtes Kunststoffelement mit rechteckigem oder quadratischem Umriss ausgebildet. Der Kunststoff-Träger 1 hat die Gestalt eines flachen oder flächigen Bauteils, bei welchem Strukturen aus einem flachen, plattenförmigen, eine Grundebene 107 bildenden Bereich hervorragen. Entlang einer ersten lateralen Richtung weist der Kunststoff-Träger 1 Regenwasser-Abführelemente 10 auf, welche bei Schrägstellung des Kunststoff-Trägers 1 Regenwasser entlang dieser lateralen Richtung, beziehungsweise in Richtung des Gefälles leiten. Insbesondere ist es zweckmäßig, entlang einer Kante 110 des Kunststoff-Trägers 1 verlaufende, aus der Grundebene 107 herausragende, langgestreckte Regenwasser-Abführelemente 10 vorzusehen. Demgemäß wird dann das Regenwasser in Richtung entlang dieser Kante geführt. Die Kunststoff-Träger 1 werden dann zweckmäßig so auf einem Dach montiert, dass entlang dieser Kante 110 verglichen mit den angrenzenden Kanten, nachfolgend als Querkanten 111 bezeichnet, das größere Gefälle vorliegt. Vorzugsweise verläuft die Richtung des Gefälles dabei entlang der Kante 110. Der Kunststoff-Träger 1 weist weiterhin eine Ausformung in Gestalt einer Erhöhung 12 auf der Oberseite 14 auf, deren Rand 120 in einem Abstand zur Umrandung 11 des Kunststoff-Trägers 1 verläuft. Auf der Erhöhung 12 sind Montagepunkte 18 angeordnet, um an diesen Punkten Befestigungsmittel durch den Kunststoff-Träger 1 hindurch zu führen und an einer Unterkonstruktion zu befestigen. Außerdem weist der Kunststoff-Träger 1 weiterhin Rastelemente 20, 22 zur rastenden Fixierung eines Photovoltaik-Moduls auf. Diese ermöglichen insbesondere in Verbindung mit Rastelementen eines passenden Photovoltaik-Moduls die Fixierung des Photovoltaik-Moduls ohne weitere, Werkzeug erfordernde Maßnahmen, wie beispielsweise Verschraubungen.

Als Montagepunkte 18 können insbesondere Durchgangsöffnungen für das Durchführen von Verschraubungen dienen. Die Erhöhung 12 in der Mitte des Kunststoff-Trägers und die Anordnung der Montagepunkte auf dieser bewirkt, dass Regenwasser am Rand der 120 der Erhöhung entlang und damit um die Montagepunkte 18 herum geleitet wird. Damit wird in sehr einfacher Weise eine Regenwasser-Abdichtung für die Montagepunkte 18 erzielt.

Wie weiterhin anhand von Fig. 1 zu erkennen ist, sind die Montagepunkte 18 zur Umrandung 11 nach innen versetzt angeordnet. Vorzugsweise beträgt dabei der Abstand eines Montagepunkts 18 zur Umrandung 11 mindestens ein Sechstel, vorzugsweise mindestens ein Fünftel der Breite des Kunststoff-Trägers 1. Dies bewirkt gegenüber einer randseitigen Montage, dass die Montagepunkte 18 beim Aneinandersetzen der Kunststoffträger auf dem Dach möglichst gleichmäßig verteilt werden, was für eine bessere Verteilung der Kräfte bei auf die montierten Module wirkenden Sog- und/oder Druckmomenten.

Um Sog- und Druckkräfte besser ableiten zu können, ist insbesondere vorgesehen, wie bei der in Fig. 1 gezeigten Ausführungsform die Rastelemente 20, welche vertikale Kräfte aufnehmen, nahe an den Montagepunkten 18 anzuordnen. Bei der in Fig. 1 gezeigten Ausführungsform sind die Rastelemente 20 direkt neben den Montagepunkten angeordnet. Der Kraftfluss des Systems wird damit so ausgelegt, das eine auftretende Druck-/Soglast direkt - und somit optimal - in die Dachunterkonstruktion eingeleitet wird. Bei heute üblichen Auf-Dach-Systemen befindet sich der Modulbefestigungspunkt demgegenüber typischerweise jeweils außen am Modulrahmen und somit weit weg von dem Krafteinleitungspunkt in die Unterkonstruktion. Um eine optimale Weiterleitung von Sog- und Drucklasten in die Dachunterkonstruktion zu ermöglichen, sind daher, ohne Beschränkung auf die spezielle in Fig. 1 gezeigte Ausführungsform der Erfindung Rastelemente 20 zur Arretierung in Richtung senkrecht zur Oberseite eines Photovoltaik-Moduls 3, beziehungsweise senkrecht zur Oberseite des Kunststoff-Trägers 1 vorgesehen, welche in einem Abstand von höchstens einem Sechstel, vorzugsweise von höchstens einem Zehntel der längsten Seitenabmessung des Kunststoff-Trägers 1 vom nächstliegenden Montagepunkt 18 entfernt angeordnet sind.

Besonders bevorzugt wird, wie auch in Fig. 1 dargestellt, eine Erhöhung 12 in Gestalt einer Hochsicke 121, welche eine Öffnung 16 im Kunststoff-Träger 1 umrahmt. Die Öffnung 16 sorgt für eine gute Hinterlüftung der Photovoltaik-Module. Zudem wird das Gewicht des Kunststoff-Trägers 1 reduziert und Material eingespart.

Mit anderen Worten sind also die vorzugsweise vier Montagepunkte 18, insbesondere Verschraubungspunkte des Kunststoff-Trägers 1 in eine Hochsicke gelegt, welche außerhalb der Wasserführung liegt. Insbesondere können die Montagepunkte 18 so angeordnet sein, dass diese zusätzlich durch das später aufgesetzte Photovoltaik-Modul verdeckt und so optimal vor Regen- und Spritzwasser geschützt sind.

Generell sind die Regenwasser-Abführelemente 10 so ausgebildet, dass schräg ablaufendes Regenwasser in Richtung des Gefälles, also in Richtung entlang einer Seite des Kunststoff-Trägers geführt wird und somit nicht seitlich ablaufen kann. Demgemäß kann mit den erfindungsgemäßen Kunststoff-Trägern 1 eine regendichte Dachabdichtung erzielt werden.

Um eine regendichte Abdichtung beim Aneinandersetzen der Kunststoff-Träger 1 zu erhalten, sind in Weiterbildung der Erfindung beiderseitig der Erhöhung am Rand des Kunststoff-Trägers 1 Sicken 100 als Regenwasser-Abführelemente 10 vorgesehen, deren Ober- und Unterseiten komplementär geformt sind, so dass sich zwei Kunststoff-Träger 1 seitlich versetzt mit ineinandergreifenden Sicken 100 aufeinandersetzen lassen. Die Sicken 100 verhindern dabei nicht nur, dass schräg zur Gefällerichtung laufendes Wasser seitlich von den Kunststoff-Trägern 1 ablaufen und damit in das Dach eindringen kann. Derartige beiderseitig vorhandene Sicken 100 ermöglichen auch eine wahlfreie Verlegerichtung bei der Montage auf dem Dach. Die Kunststoff-Träger 1 können also in horizontaler Richtung sowohl von rechts nach links, als auch in umgekehrter Richtung überlappend aufeinandergesetzt werden, was den Montageaufwand verringert.

Die Wasserführung erfolgt also erfindungsgemäß direkt über den Kunststoff-Träger, ohne dass zusätzliche Maßnahmen (wie z. B. zusätzliche Rinnen oder Dichtungen) erforderlich sind. Dabei wird die Regensicherheit sowohl in horizontaler Richtung, als auch in vertikaler Richtung durch entsprechende Überlappungen - gemäß der Regeln für das Dachdeckerhandwerk - sichergestellt.

Um die Regendichtheit in vertikaler Richtung, beziehungsweise in Richtung der Dachneigung sicherzustellen und die Kunststoffträger einfach entlang dieser Richtung überlappend aufeinandersetzen zu können, weist der Kunststoff-Träger 1 gemäß noch einer Weiterbildung der Erfindung an den Rändern mit den Querkanten 111 ebenfalls an Ober- und Unterseite komplementär geformte Ausformungen auf. Wie anhand von Fig. 1 zu erkennen ist, ist auch diese Weiterbildung bei der abgebildeten Ausführungsform durch die Sicken 100, sowie gegebenenfalls weitere ausgeformte Elemente realisiert.

Die komplementären Ausformungen auf Vorder- und Rückseite des Kunststoff-Trägers 1 ermöglichen ein einfaches passgenaues Aneinandersetzen der Kunststoff-Träger 1 auf dem Dach. Die erste Modulwanne, beziehungsweise der erste Kunststoff-Träger 1 kann dabei auf dem Dach durch entsprechendes Vermessen positioniert werden. Alle weiteren Kunststoff-Träger 1 positionieren sich durch die seitliche, bzw. vertikale Überlappung selbsttätig, so dass sich der Messaufwand auf ein Minimum beschränkt. Der Messaufwand bei heute üblichen Auf-Dach-, oder InDach-Systemen ist demgegenüber wesentlich aufwändiger.

Der Kunststoff-Träger 1 kann allgemein als Gleichteil ausgeführt sein, d. h. jeder Kunststoff-Träger 1 kann damit an einer beliebigen Stelle des Modulfeldes montiert werden. Dies ermöglicht eine einfache Installation der Kunststoff-Träger 1 und optimiert auch die Logistik in den Punkten Verpackung (jeder Träger 1 kann gleich verpackt werden) und Transport. Zu letzterem Punkt ist in Weiterbildung der Erfindung der Kunststoff-Träger 1 stapelbar und damit für den Transport platzsparend ausgebildet. Unter einem stapelbaren Kunststoff-Träger 1 wird dabei im Sinne der Erfindung ein Kunststoff-Träger mit Ausformungen verstanden, dessen Ober- und Unterseite zumindest teilweise komplementär sind, so dass beim Aufeinandersetzen eines Kunststoff-Trägers 1 mit dessen Unterseite auf die Oberseite eines weiteren Kunststoff-Trägers 1 mit fluchtenden Kanten die Gesamthöhe der so aufeinandergestapelten beiden Kunststoff-Träger geringer ist als die doppelte Höhe eines einzelnen Kunststoff-Trägers 1.

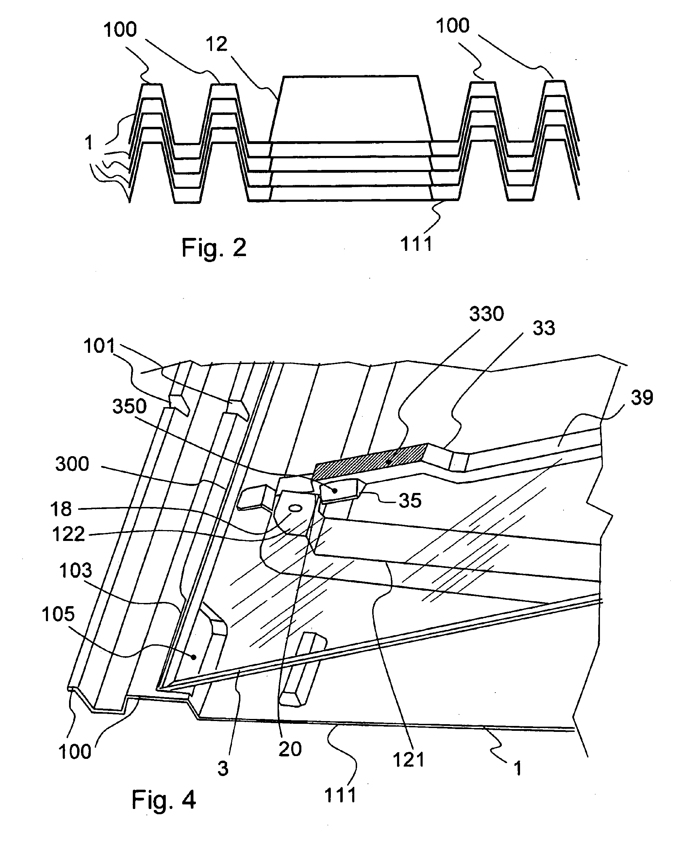

Ein Beispiel hierzu zeigt Fig. 2. In Fig. 2 sind schematisch fünf aufeinandergestapelte Kunststoff-Träger 1 in Blickrichtung auf die Querkante 111 dargestellt. Wie anhand von Fig. 2 zu erkennen ist, sind sowohl die Sicken 100 beidseitig, als auch die Erhöhung 12 an Ober- und Unterseite jeweils komplementär ausgebildet, so dass sich die Kunststoff-Träger 1 aufeinanderstapeln lassen.

Als Kunststoff ist in den erfindungsgemäßen Verfahren grundsätzlich jedes thermoplastische verarbeitbare Polymer einsetzbar. Gemäß einer bevorzugten Weiterbildung der Erfindung ist der Kunststoff-Träger daher aus einer thermoplastischen Formmasse gefertigt. Insbesondere geeignet sind ein oder mehrere Kunststoffe ausgewählt aus Polyethylen, Polypropylen, Polyvinylchlorid, Polystyrol, schlagfest modifiziertem Polystyrol (HiPS), AcrylnitrilButadien-Styrol-Copolymeren (ABS), Acrylnitril-Styrol-Acrylat-Copolymeren (ASA), Methacrylat-AcrylnitrilButadien-Styrol-Copolymeren (MABS), Styrol-Butadien-Blockcopolymeren, Polyamid, Polyethylenterephthalat (PET), Polyethylenterephthalatglycol (PETG), Polybutylenterephthalat (PBT), Polyoxymethylen (POM), Polycarbonat (PC), Polymethylmethacrylat (PMMA), Poly(ether)sulfonen, thermoplastisch verarbeitbarem Polyurethan (TPU) und Polyphenylenoxid (PPO).

Besonders bevorzugte Kunststoffe sind Polyamide.

Die genannten Kunststoffe können in reiner Form oder als Mischung mit kunststoffüblichen Hilfsstoffen eingesetzt werden. In einer bevorzugten Ausführungsform werden mit faserförmigen oder teilchenförmigen Füllstoffen versehene Kunststoffe eingesetzt.

Es hat sich gezeigt, dass die thermoplastische Formmasse noch formgebend mit einem Anteil faserförmiger und/oder teilchenförmiger Füllstoffe von bis zu 70 Gewichtsprozent, vorzugsweise im Bereich von 10 bis 60 Gewichtsprozent, besonders bevorzugt 20 bis 50 Gewichtsprozent formgebend, insbesondere durch Spritzguss oder Spritzprägedruck zur Herstellung der erfindungsgemäßen, vergleichsweise großflächigen Kunststoff-Träger 1 verarbeitbar ist. Der hohe Anteil von faser- und/oder teilchenförmigen Füllstoffen erhöht dabei die Festigkeit und Langlebigkeit des Kunststoff-Trägers 1.

Gemäß noch einer Weiterbildung werden der thermoplastischen Formmasse Pigmente und/oder Stabilisatoren zur Verbesserung der Witterungsbeständigkeit und oder der Brandeigenschaften beigemischt. Diese Pigmente und/oder Stabilisatoren können einen Anteil der vorgenannten faser- oder teilchenförmigen Füllstoffe bilden oder zusätzlich zu den faser- oder teilchenförmigen Füllstoffen hinzugegeben werden.

Besonders geeignete Füllstoffe sind Glasfasern, Glaskugeln, mineralische Füllstoffe, oder so genannte Nanopartikel.

Ganz besonders bevorzugte Kunststoffe sind glasfaserverstärkte Polyamide. Als Polyamide eignen sich prinzipiell alle bekannten Polyamide. In Betracht kommen beispielsweise Polyamide mit aliphatischem, teilkristallinem oder teilaromatischem sowie amorphem Aufbau jeglicher Art und deren Blends, einschließlich Polyetheramiden wie Polyetherblockamiden.

Halbkristalline oder amorphe Harze mit einem Molekulargewicht (Gewichtsmittelwert) von mindestens 5.000, wie sie z.B. in den US-PS 2 071 250, 2 071 251, 2 130 523, 2 130 948, 2 241 322, 2 312 966, 2 512 606 und 3 393 210 beschrieben werden, sind bevorzugt.

Beispiele hierfür sind Polyamide, die sich von Lactamen mit 7 bis 13 Ringgliedern ableiten, wie Polycaprolactam, Polycapryllactam und Polylaurinlactam, sowie Polyamide, die durch Umsetzung von Dicarbonsäuren mit Diaminen erhalten werden.

Als Dicarbonsäuren sind Alkandicarbonsäuren mit 6 bis 12, insbesondere 6 bis 10 Kohlenstoffatomen und aromatische Dicarbonsäuren einsetzbar. Hier seien Adipinsäure, Azelainsäure, Sebacinsäure, Dodecandisäure (=Decandicarbonsäure) und Terephthal- und/oder Isophthalsäure als Säuren genannt.

Als Diamine eignen sich besonders Alkandiamine mit 6 bis 12, insbesondere 6 bis 8 Kohlenstoffatomen sowie m-Xylylendiamin, Di-(4-aminophenyl)methan, Di-(4-aminocyclohexyi)-methan, Di-(4-amino-3-methyl-cyclohexyl)-methan, Isophorondiamin, 1,5-Diamino-2-methyl-pentan, 2,2-Di-(4-aminophenyl)-propan oder 2,2-Di-(4-aminocyclohexyl)-propan.

Bevorzugte Polyamide sind insbesondere Polyhexamethylenadipinsäureamid (PA 66) und Polyhexamethylensebacinsäureamid (PA 610), Polycaprolactam (PA 6) sowie Copolyamide 6/66, insbesondere mit einem Anteil von 5 bis 95 Gew.-% an Caprolactam-Einheiten.

Bevorzugt ist das Polyamid ausgewählt aus PA 6, PA 66 und Copolyamid 6/66; PA 6 ist ganz besonders bevorzugt.

Weitere geeignete Polyamide sind erhältlich aus ω-Aminoalkylnitrilen wie z.B. Aminocapronitril (PA 6) und Adipodinitril mit Hexamethylendiamin (PA 66) durch sog. Direktpolymerisation in Anwesenheit von Wasser, wie beispielsweise in der DE-A 10313681, EP-A 1198491 und EP-A 922065 beschrieben.

Außerdem seien auch noch Polyamide erwähnt, die z.B. durch Kondensation von 1,4-Diaminobutan mit Adipinsäure unter erhöhter Temperatur erhältlich sind (Polyamid 46).

Herstellungsverfahren für Polyamide dieser Struktur sind z.B. in den EP-A 38 094, EP-A 38 582 und EP-A 39 524 beschrieben.

Weitere Beispiele sind Polyamide, die durch Copolymerisation zweier oder mehrerer der vorgenannten Monomeren erhältlich sind, oder Mischungen mehrerer Polyamide geeignet, wobei das Mischungsverhältnis beliebig ist.

Weiterhin haben sich solche teilaromatischen Copolyamide wie PA 6/6T und PA 66/6T als besonders vorteilhaft erwiesen, deren Triamingehalt weniger als 0,5, vorzugsweise weniger als 0,3 Gew.-% beträgt (siehe EP-A 299 444). Die Herstellung der teilaromatischen Copolyamide mit niedrigem Triamingehalt kann nach den in den EP-A 129 195 und 129 196 beschriebenen Verfahren erfolgen.

Die nachfolgende, nicht abschließende Aufstellung enthält die genannten, sowie weitere Polyamide im Sinne der Erfindung und die enthaltenen Monomeren:
AB-Polymere:
   PA 6 ε-Caprolactam
   PA 7 Ethanolactam
   PA 8 Capryllactam
   PA 9 9-Aminopelargonsäure
   PA 11 11-Aminoundecansäure
   PA 12 Laurinlactam.
AA/BB-Polymere:
   PA 46 Tetramethylendiamin, Adipinsäure
   PA 66 Hexamethylendiamin, Adipinsäure
   PA 69 Hexamethylendiamin, Azelainsäure
   PA 610 Hexamethylendiamin, Sebacinsäure
   PA 612 Hexamethylendiamin, Decandicarbonsäure
   PA 613 Hexamethylendiamin, Undecandicarbonsäure
   PA 1212 1,12-Dodecandiamin, Decandicarbonsäure
   PA 1313 1,13-Diaminotridecan, Undecandicarbonsäure
   PA 6T Hexamethylendiamin, Terephthalsäure
   PA MXD6 m-Xylylendiamin, Adipinsäure
   PA 61 Hexamethylendiamin, Isophthalsäure
   PA 6-3-T Trimethylhexamethylendiamin, Terephthalsäure
   PA 6/6T (siehe PA 6 und PA 6T)
   PA 6/66 (siehe PA 6 und PA 66)
   PA 6/12 (siehe PA 6 und PA 12)
   PA 66/6/610 (siehe PA 66, PA 6 und PA 610)
   PA 6I/6T (siehe PA 61 und PA 6T)
   PA PACSV1 12 Diaminodicyclohexylmethan, Laurinlactam
   PA 6I/6T/PACM wie PA 6I/6T + Diaminodicyclohexylmethan
   PA 12/MACMI Laurinlactam, Dimethyldiaminodicyclohexylmethan, Isophthalsäure
   PA 12/MACMT Laurinlactam, Dimethyldiaminodicyclohexylmethan, Terephthalsäure
   PA PDA-T Phenylendiamin, Terephthalsäure.

Die Polyamide und ihre Herstellung sind bekannt, beispielsweise aus Ullmanns Encyklopädie der Technischen Chemie, 4. Auflage, Bd. 19, S. 39-54, Verlag Chemie, Weinheim 1980; Ullmanns Encyclopedia of Industrial Chemistry, Vol. A21, S. 179-206, VCH Verlag, Weinheim 1992; Stoeckhert, Kunststofflexikon, 8. Auflage, S. 425-428, Carl Hanser Verlag München 1992 (Stichwort "Polyamide" und folgende), sowie Saechtling, Kunststoff-Taschenbuch, 27. Ausgabe, Carl Hanser-Verlag München 1998, Seiten 465-478.

Auf die Herstellung der bevorzugten Polyamide PA6, PA 66 und Copolyamid 6/66 wird nachfolgend kurz eingegangen. Die Polymerisation bzw. Polykondensation der Ausgangsmonomere zum Polyamid wird vorzugsweise nach den üblichen Verfahren durchgeführt. So kann die Polymerisation des Caprolactams beispielsweise nach den in der DE-A 14 95 198 und DE-A 25 58 480 beschriebenen kontinuierlichen Verfahren erfolgen.

Die Polymerisation von AH-Salz zur Herstellung von PA 66 kann nach dem üblichen diskontinuierlichen Verfahren (siehe: Polymerization Processes S. 424-467, insbesondere S. 444-446, Interscience, New York,1977) oder nach einem kontinuierlichen Verfahren, z.B. gemäß EP-A 129 196, erfolgen.

Bei der Polymerisation können übliche Kettenregler mitverwendet werden. Geeignete Kettenregler sind z.B. Triacetondiaminverbindungen (siehe WO-A 95/28443), Monocarbonsäuren wie Essigsäure, Propionsäure und Benzoesäure, Dicarbonsäuren wie Adipinsäure, Sebacinsäure, Cyclohexan-1,4-Dicarbonsäure, Isophthalsäure und Terephthalsäure sowie Basen wie Hexamethylendiamin, Benzylamin und 1,4-Cyclohexyldiamin geeignet.

Die erhaltene Polymerschmelze wird aus dem Reaktor ausgetragen, gekühlt und granuliert.

Das erhaltene Granulat kann einer Nachpolymerisation unterworfen werden, die in der Regel 2 bis 24 Stunden dauert. Dies geschieht in an sich bekannter Weise durch Erwärmen des Granulats auf eine Temperatur T unterhalb der Schmelztemperatur Ts bzw. Kristallitschmelztemperatur Tₖ des Polyamids. Durch die Nachpolymerisation stellt sich das endgültige Molekulargewicht des Polyamids (messbar als Viskositätszahl VZ, siehe Angaben zur VZ weiter unten) ein. Geeignete Polyamide weisen im Allgemeinen eine Viskositätszahl VZ von 50 bis 250, vorzugsweise 70 bis 200 und besonders bevorzugt 80 bis 150 ml/g auf, bestimmt gemäß ISO 307 EN an einer 0,5 gew.-%igen Lösung des Polyamids in 96 gew.-%iger Schwefelsäure bei 25°C. Diesen Viskositätszahlen entsprechen hohe Molekulargewichte.

Für die vorliegende Erfindung besonders geeignete Polyamide sind glasfaserverstärkte, hoch-fließfähige und wärmebeständige Polyamide, wie sie beispielsweise beschrieben werden in WO 2006/042705. Insbesondere geeignet ist ein Ultramid® "Highspeed" der BASF SE.

Als Herstellungsverfahren der erfindungsgemäßen Kunststoff-Träger kommen verschiedene Fertigungstechniken wie z.B. Thermoformen oder Spritzgießen in Frage. Im Falle vom Thermoformen werden aus den ausgewählten Kunststoffen zunächst im Extrusionsverfahren Platten hergestellt. Diese werden dann im sogenannten Thermoformprozess erwärmt - z.B. mit IR-Strahlern - und in einem dreidimensionalen Thermoformwerkzeug umgeformt.

Um komplexe dreidimensionale Bauteile, wie die erfindungsgemäßen Kunststoff-Träger aus thermoplastischen Kunststoffen herzustellen, has sich insbesondere das Spritzgießen bewährt. Aufgrund der Bauteilgröße sind hier bevorzugt Werkzeuge mit Heißkanalsystemen zu verwenden.

Durch die Verwendung einen Heißkanal-Verteilers, der die Kunststoffschmelze an verschiedene Düsen verteilt, kann der für die Werkzeugfüllung erforderliche Fließweg deutlich reduziert werden.

Bei großflächigen Bauteilen kann auch ein Spritzgussverfahren mit Kaskadensteuerung zur Anwendung gelangen. Dabei wird der Kunststoff durch mehrere, in Fließrichtung des Kunststoffs hintereinander angeordnete Düsen eingespritzt. Die Steuerung der Einspritzung des Kunststoffs erfolgt dabei in der Weise, dass der Kunststoff erst zu dem Zeitpunkt durch eine Düse eingespritzt wird, wenn die Düse durch den Kunststoff, der aus der in Fließrichtung des eingespritzten Kunststoffs davor angeordneten Düse eingespritzt wurde, überdeckt ist. Die Einspritzung des Kunststoffs erfolgt also zeitlich versetzt. Da der durch den Kunststoff zurückzulegende Fließweg trotz der Bauteilgröße so begrenzt wird, können trotz geringer Wanddicke größere Bauteile reduziert werden.

Ein weiteres Sonderverfahren, das sich insbesondere bei großflächigen Bauteilen bewährt hat, ist das Spitzprägen.

Hier wird das Werkzeug zu Beginn nicht vollständig geschlossen. Der Werkzeugspalt, den die Kunststoffschmelze durchfließen muss, hat dadurch eine größere Höhe, was zu einem geringeren Druckverlust führt. Das vollständige Schließen des Werkzeugs erfolgt bei diesem Verfahren erst wenn die Schmelze teilweise oder komplett in das Werkzeug eingespritzt wurde. Die Prägephase kann dabei zum einen durch die Bewegung einer Werkzeughälfte erfolgen oder zum anderen durch die Verwendung von beweglichen Werkzeugeinsätzen, die z.B. hydraulisch angesteuert werden.

Ein weiteres Sonderverfahren mit dem vor allem bei großflächigen Bauteilen zum einen der erforderliche Einspritzdruck als auch der Verzug reduziert werden können ist die Verwendung von physikalischen oder chemischen Treibmitteln für den Spritzguß oder das Spritzprägen.

Mit den erfindungsgemäßen Kunststoff-Trägern kann gemäß einer Weiterbildung der Erfindung auch ein automatischer Toleranzausgleich erzielt werden. Jedes Dach hat eine mehr oder weniger ausgeprägte Unebenheit. Bei Auf-Dach-Modulen wird dies bisher durch die Justage der Dachhacken ausgeglichen, bei gängigen In-Dach-Systemen durch Nivellierung der Unterkonstruktion.

Ein erfindungsgemäßes Kunststoff-Trägerteil kann aber insbesondere auch verwindbar ausgebildet sein. Um dies zu erzielen, sind die oben genannten Kunststoffe, insbesondere faserverstärkte Polyamide geeignet. Polyamide zeichnen sich durch für Thermoplaste hohe Elastizität aus, was die Verwindbarkeit verbessert. Weiterhin sind vorzugsweise, wie auch bei der in Fig. 1 gezeigten Ausführungsform am Rand, beziehungsweise im Bereich der Umrandung 11 Ausformungen vorhanden, deren Längsrichtungen parallel oder im wesentlichen parallel verlaufen. Bei der dargestellten Ausführungsform werden diese Ausformungen insbesondere durch die parallel verlaufenden Sicken 100 realisiert. Auf diese Weise kann eine Torsion um eine Achse entlang der Längsrichtung der Sicken 100 oder allgemeiner der Regenwasser-Abführelemente 10 erfolgen. Damit wird der Ausgleich eines Höhenunterschieds einer Unterkonstruktion unterhalb des Kunststoff-Trägers 1 von bis zu 10 mm ermöglicht. Dieser Wert bezieht sich auf einen Kunststoff-Träger 1 für ein Modul der Größe 1.685 mm x 993 mm.

Ein hoher Risikofaktor bei dachintegrierten Photovoltaik-Systemen stellt die Kabelführung und die damit verbundene Quetschgefahr des Kabels dar. Beim Abstellen des Moduls oder direkt bei der Montage kann es zur Quetschung des Kabels zwischen Unterkonstruktion und Modul kommen. Um dies zu verhindern wird in Weiterbildung der Erfindung in den Kunststoff-Träger 1 eine Aussparung für die Kabelführung, integriert. Somit können die Photovoltaik-Module 3 sicher miteinander verbunden werden. Wie in Fig. 1 dargestellt, ist die Aussparung als in die Sicken 100 eingeformter, oben offener Kabelkanal 101 ausgeführt. Der Kabelkanal 101 unterbricht aber nur einen oberen Teil der Sicken 100, so dass vermieden wird, dass abfließendes Regenwasser quer durch den Kabelkanal 101 ablaufen und unter die überlappend nebeneinander befestigten Kunststoff-Träger 1 geraten und in das Dach eindringen kann. Mit anderen Worten verläuft der Kabelkanal 101 oberhalb der Grundebene 107 des Kunststoff-Trägers, auf welcher das Wasser abfließt. Demgemäß ist in Weiterbildung der Erfindung im Kunststoff-Träger 1 zumindest ein Kabelführungselement, vorzugsweise in Gestalt eines halboffenen Kanals vorgesehen, welches oberhalb einer Grundebene 107 des Kunststoff-Trägers 1 verläuft.

Nachfolgend wird ein zum Kunststoff-Träger 1 passendes Photovoltaik-Modul gemäß einer Ausführungsform der Erfindung beschrieben.

Allgemein ermöglicht der Kunststoff-Träger 1 die Verwendung eines rahmenlosen Moduls, insbesondere ausgestaltet als Doppelglasmodul.

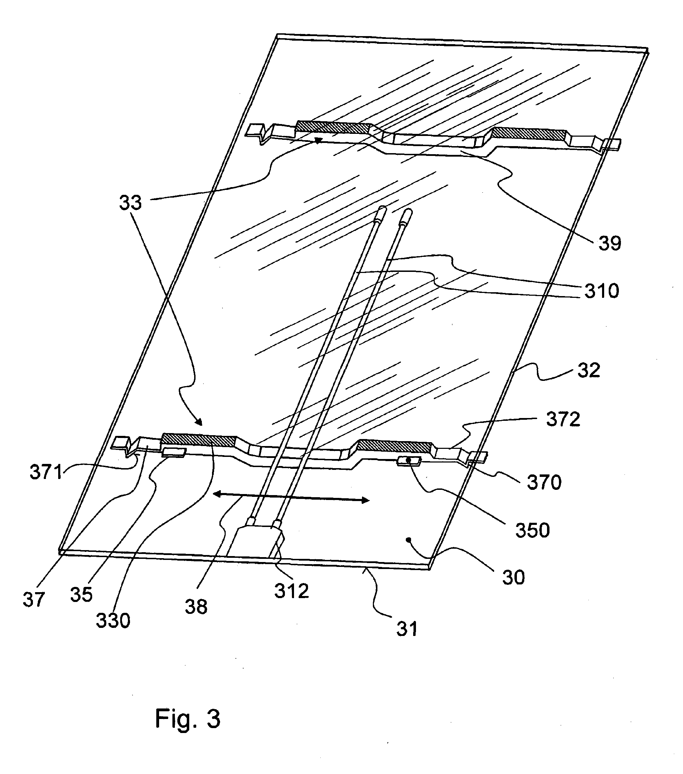

Eine Ansicht eines Photovoltaik-Modul 3 gemäß einer Ausführungsform der Erfindung ist in Fig. 3 dargestellt. Fig. 3 zeigt dabei das Photovoltaik-Modul 3 in Aufsicht auf die Vorderseite 30, also die photovoltaisch aktive Seite. Das Photovoltaik-Modul 3 umfasst eine Glasscheibe 32 als Träger oder Abdeckung der photoaktiven Schicht des Moduls 3 Die Glasscheibe 32 ist zum Zwecke der Illustration durchsichtig dargestellt, um die rückseitig angebrachten Befestigungselemente sichtbar zu machen.

In Fig. 3 sind die Anschlusskabel 310 dargestellt, welche mit einer Anschlussdose 312 verbunden sind. Diese Anschlusskabel 310 werden bei der Montage des Photovoltaik-Moduls 3 auf dem Kunststoff-Träger in die Kabelkanäle 101 eingelegt. Beim nachfolgenden lateralen Verschieben des Photovoltaik-Moduls 3 zur Arretierung auf dem Kunststoff-Träger 1 wird damit vermieden, dass die Anschlusskabel 310 zwischen Modul und Kunststoff-Träger 1 gequetscht und beschädigt werden.

Das erfindungsgemäße Photovoltaik-Modul zeichnet sich durch auf dessen Rückseite 31 befestigte, vorzugsweise aufgeklebte Modulhalter 33 aus, welche gleichzeitig zur Befestigung am Kunststoff-Träger 1 dienen. Durch die Art und Weise der Befestigung, beziehungsweise die Ausgestaltung der Modulhalter mit Rastelementen ist kein Modulrahmen mehr notwendig - die typischen Aufgaben des Modulrahmens (Befestigungspunkte und Versteifung des Moduls) werden von den Modulhaltern 33 und der später erläuterten Befestigung am Kunststoff-Träger 1 übernommen.

Jeder Modulhalter 33 ist mit zumindest einer Klebefläche 330 auf der Rückseite 31 aufgeklebt. Vorzugsweise wird die Rückseite 31, ebenso wie die Vorderseite 30 durch je eine Glasscheibe gebildet, wobei die photoaktive Schicht zwischen den Glasscheiben angeordnet ist. Demgemäß stellt das Photovoltaik-Modul 3 ein rahmenloses Doppelglas-Modul dar.

Derzeitige Standard-Module müssen an dem teilweise unhandlichen Modulrahmen gehandhabt werden. Demgegenüber sind in Weiterbildung der Erfindung an den Modulhaltern 33 Handgriffe 39 ausgebildet, mit welchen das Photovoltaik-Modul 3 einfach und sicher handhabbar ist.

Das Photovoltaik-Modul 3 weist zu den Rastelementen 20, 22 des Kunststoff-Trägers 1 korrespondierende Rastelemente 35, 37 auf. Die Verrastungsrichtung 38 ist bei dem in Fig. 3 gezeigten Beispiel entlang der Längsrichtung der Modulhalter 33. Um das Photovoltaik-Modul 3 in Richtung senkrecht zur Oberfläche zu arretieren, sind als Rastelemente 35 Rastnasen vorgesehen, welche quer zur Verrastungsrichtung 38 aus dem Grundkörper des Modulhalters 33 herausragen. Für die vertikale Arretierung weisen dabei die Rastnasen 35 Arretierungsflächen 350 auf, die vorzugsweise parallel zur Vorderseite 30 oder Rückseite 31 des Photovoltaik-Moduls liegen, jedenfalls aber Auflagepunkte für ein korrespondierendes Rastelement des Kunststoff-Trägers 1 definieren, welche eine vertikale Bewegung in Richtung senkrecht zur Vorderseite 30 blockieren. Mit anderen Worten weisen die Arretierungsflächen 350 eine Komponente der Flächennormalen auf, welche parallel zur Richtung der Flächennormalen der Vorderseite 30 oder der Rückseite 31 liegt, um in Kontakt mit einem Rastelement einer Halterung eine Bewegung in Richtung dieser Flächennormalen zu blockieren.

Als weitere Rastelemente 37 sind federnd gelagerte Haken vorgesehen. Die Haken 37 weisen eine quer zur Verrastungsrichtung 38 liegende Sperrfläche 370, sowie eine schräg zur Verrastungsrichtung 38 und damit auch schräg zur Fläche der Rückseite 31 verlaufende Führungsfläche 371 auf. Die Rasthaken 37 sind so federnd gelagert, dass diese sich in Richtung quer zur Rückseite 31 bewegen lassen.

An jedem Modulträger 33 sind die Haken 37 jeweils doppelt vorhanden, wobei die Haken gegenläufig, beziehungsweise spiegelsymmetrisch zueinander orientiert sind. Diese Anordnung der Rastelemente erlaubt es, das Photovoltaik-Modul 3 durch Auflegen und anschließende seitliche Verschiebung auf einem Träger mit korrespondierenden Rastmitteln, wie insbesondere dem Kunststoff-Träger 1 zu arretieren, wobei aufgrund der spiegelsymmetrischen Anordnung der Haken 37 die Arretierung durch laterale Verschiebung wahlweise entlang zweier gegenläufiger Verrastungsrichtungen 38 erfolgen kann. Aus diesem Grund ist die Verrastungsrichtung 38 in Fig. 3 als Doppelpfeil dargestellt. Die Verrastung in lateraler Richtung erfolgt dabei durch Anlage der Sperrflächen 370 an korrespondierende, gegenüberliegende Sperrflächen des jeweiligen Trägers, so dass jede der Sperrflächen 371 der beiden Haken 37 jeweils eine Bewegung in einer lateralen Richtung blockiert. Demgemäß ist durch Anlage der Sperrflächen 370 an feststehenden Elementen, wie etwa korrespondierende Sperrflächen einer Halterung eine Arretierung in Richtung parallel zur Fläche der Glassscheibe, beziehungsweise parallel zur Vorder- oder Rückseite des Photovoltaik-Moduls 3 bewirkbar.

Die federnde Lagerung der Haken 37 und dessen Führungsflächen 371 ermöglichen, dass der bei der Verrastung in Bewegungsrichtung 38 nachlaufende Haken 37 durch Gleiten der schrägen Führungsfläche 371 auf einem Element des Trägers angehoben wird und nach Passieren der Sperrfläche des Trägers zurückfedern kann, so dass sich die Sperrflächen des Hakens und des Trägers gegenüberstehen.

Bei der in Fig. 3 gezeigten Ausführungsform wird die federnde Halterung des Hakens 37 durch einen Blattfederarm 372 bereitgestellt. Sind, wie bevorzugt, die Modulträger 33 aus Kunststoff gefertigt, können die Rastelemente 35, 37 inklusive des Blattfederarms 372 in einfacher Weise einstückig hergestellt werden. Anders als in Fig. 3 gezeigt, ist es auch denkbar, die Haken 37 in Richtung entlang der Vorder- oder Rückseite 30, 31 beweglich auszubilden.

Diese Montage und Arretierung auf dem Kunststoff-Träger 1 wird nachstehend anhand der weiteren Figuren noch genauer erläutert. Jedenfalls können die vorstehend beschriebenen Merkmale eines erfindungsgemäßen Photovoltaik-Moduls 3 ohne Beschränkung auf die wie folgt zusammengefasst werden:
Das Photovoltaik-Modul 3 ist rahmenlos und weist zumindest eine die photovoltaisch aktive Schicht abdeckende Scheibe, vorzugsweise eine Glasscheibe auf, welche die Vorderseite des Photovoltaik-Moduls 3 bildet, wobei auf der gegenüberliegenden Rückseite des Photovoltaik-Moduls 3 Modulträger 33 aufgeklebt sind, und wobei die Modulträger 33 jeweils zwei Rastelemente (bei der in Fig. 3 gezeigten Ausführungsform die Haken 37) an gegenüberliegenden Enden des Modulträgers 33 aufweisen, welche federnd beweglich ausgebildet sind, und wobei diese Rastelemente in entgegengesetzte Richtungen weisende Sperrflächen 370 aufweisen, und wobei die Modulträger 33, wie oben beschrieben, weitere Rastelemente (in Fig. 3 im Speziellen die Rastnasen 35) mit Arretierungsflächen 350 aufweisen, wobei die Arretierungsflächen 350 eine Komponente der Flächennormalen aufweisen, welche parallel zur Richtung der Flächennormalen der Glasscheibe, oder der Vorder- oder Rückseite liegt, um in Kontakt mit einem Rastelement einer Halterung eine Bewegung in Richtung dieser Flächennormalen zu blockieren.

Vorzugsweise ist an den Modulträgern, wie bereits oben gesagt, ein Handgriff 39 ausgebildet, beziehungsweise umgekehrt ausgedrückt, sind die Modulträger 33 als Handgriffe 39 ausgebildet.

Fig. 4 zeigt ausgehend von den in Fig. 1 und 3 gezeigten Elementen anhand einer vergrößerten Ansicht einen ersten Verfahrensschritt zur Fixierung eines Photovoltaik-Moduls 3 auf dem Kunststoff-Träger 1.

Der Kunststoff-Träger 1 verfügt in Weiterbildung der Erfindung über eine speziell konstruierte Modul-Abstelleinrichtung. Diese dient der sicheren Positionierung des Photovoltaik-Moduls 3 vor dem eigentlichen Befestigungsschritt. Nach der Ablage des Photovoltaik-Moduls 3 kann risikofrei umgegriffen werden.

Diese Einrichtung ist gegenüber üblichen Montagesystemen vorteilhaft, da bei solchen Systemen oftmals zum Einbau zwei Installateure benötigt werden, um ein Modul einerseits zu halten und andererseits zu befestigen.

Für die Montage gemäß der Erfindung kann demgegenüber das Photovoltaik-Modul 3 vor der eigentlichen

Befestigung mit dessen Kante 300 auf der Abstellfläche 105 abgestellt werden, so dass die Kante 300 in Anlage mit der an die Abstellfläche 105 angrenzende Anlagekante 103 kommt.

Die Anlagekante 103 ist dabei so positioniert, dass das Photovoltaik-Modul 3 bei Anlage an dieser Kante und Ablage auf der Abstellfläche 105 in einer definierten Anfangsposition für die laterale Verschiebung des Moduls entlang des Kunststoff-Trägers 1 zur gegenseitigen Verrastung der Rastelemente 20, 22, 35, 37 von Kunststoff-Träger 1 und Photovoltaik-Modul 3 zu liegen kommt. Zur Verdeutlichung sind die Ablagekante 103 und die Abstellfläche 105 auch in Fig. 1 eingezeichnet.

Die definierte Anfangsposition besteht, wie in Fig. 4 zu erkennen ist, darin, dass die Rastnasen 35 der Modulträger 33 in Verschieberichtung gesehen vor den korrespondierenden Rastelementen 20 des Kunststoff-Trägers 1 angeordnet sind.

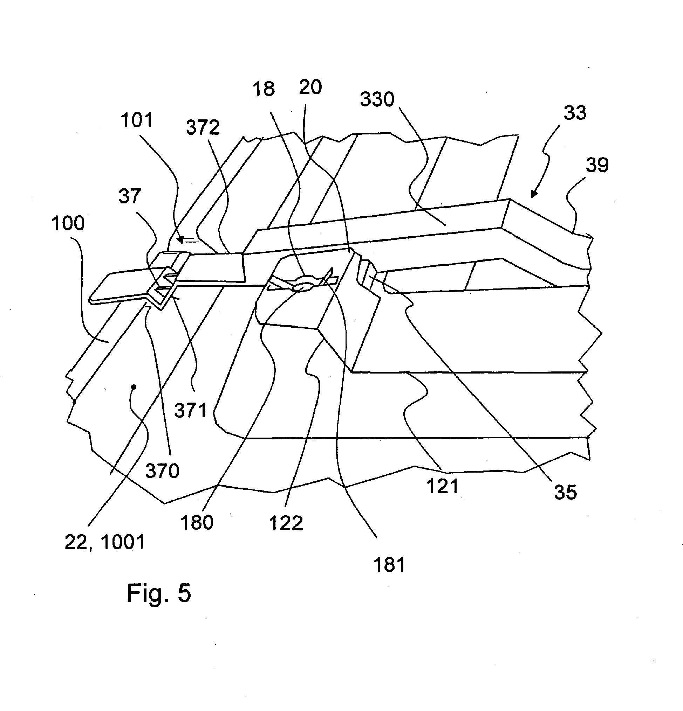

Fig. 5 zeigt zur genaueren Erläuterung der Verrastung und Fixierung des Photovoltaik-Moduls 3 auf dem Kunststoffträger einen Ausschnitt des Photovoltaik-Installationssystems mit dem verrasteten Photovoltaik-Modul 3.

Die Rastelemente 20 sind, wie auch in Fig. 4 zu erkennen ist, Vorsprünge oder Aussparungen an einer Ausformung 122, unter welche, beziehungsweise in welche dann beim Einschieben in die Verrastungsposition die Rastnasen 35 geschoben werden. Auf der Ausformung 122 sind auch die Montagepunkte 18 angeordnet. In Fig. 5 ist auch eine durch die Montagepunkte 18 in die Dachunterkonstruktion geschraubte Befestigungsschraube 180 zu erkennen.

In Weiterbildung der Erfindung sind dabei weiterhin die Photovoltaik-Module 3 in montierter Endlage durch Federkraft vorgespannt, was ein späteres Klappern durch Windeinfluss verhindert. Unter der Befestigungsschraube 180 ist dazu eine Feder 181 angebracht, welche das Photovoltaik-Modul 3 in vertikaler Richtung vorspannt und so ein späteres Klappern durch Windeinfluss auf dem Dach verhindert.

Die Verrastung in Richtung der Verrastungsrichtung 38, beziehungsweise in horizontaler Richtung wird, wie bereits oben erwähnt, durch Anlage der quer zur Verrastungsrichtung 38 liegenden Sperrfläche 370 des Hakens 37 an eine korrespondierende Sperrfläche des Kunststoff-Trägers 1 bewirkt. Diese korrespondierende Sperrfläche bildet ein Rastelement 22 zur horizontalen Arretierung des Photovoltaik-Moduls 3. Wie anhand von Fig. 5 ersichtlich, kann diese Sperrfläche in einfacher Weise durch eine Seitenwand 1001 einer Sicke 100 gebildet werden. Zur Verrastung wird dabei der in Verrastungsrichtung hinten liegende Haken 37 über die Sicke 100 hinwegbewegt, wobei die Führungsfläche 371 bei der Verschiebung durch die Sicke 100 unter elastischer Verformung des Blattfederarms 372 angehoben wird, so dass der Haken 37 über die Sicke 100 hinweggleitet. In der Verrastungsposition ist der Haken 37 über die Sicke 100 hinwegbewegt, so dass die Federkraft des Blattfederarms 372 dann den Haken 37 wieder in seine in Fig. 5 gezeigte vertikale Ausgangsposition bewegt damit die Sperrfläche 370 in Gegenüberstellung zur Seitenwand 1001 der Sicke 100 bringt. Damit verhindert die Sperrfläche 370 des Hakens 37 eine Bewegung des Moduls in einer horizontalen Richtung und der andere, in Fig. 5 nicht dargestellte, gegenüberliegende Haken 37 die Bewegung in die entgegengesetzte Richtung, so dass durch Zusammenwirkung beider Haken 37 eines Modulträgers 33 mit den Seitenwänden 1001 des Kunststoff-Trägers 1 eine horizontale Arretierung, damit also eine Arretierung in Richtung parallel zur Fläche der Glassscheibe bewirkt wird.

Ein erfindungsgemäßes Photovoltaik-Installationssystem mit einem Kunststoff-Träger 1 und einem Photovoltaik-Modul 3 zeichnet sich also allgemein dadurch aus, dass Rastelemente 20, 22, 35, 37 an Kunststoff-Träger 1 und Photovoltaik-Modul 3 vorgesehen sind, welche die Arretierung des Photovoltaik-Moduls 3 auf dem Kunststoff-Träger 1 durch Auflegen des Photovoltaik-Moduls 3 in einer Anfangsposition und lateralen Verschiebung des Photovoltaik-Moduls 3 auf dem Kunststoff-Träger 1 bis in eine in Fig. 5 dargestellte Verrastungsposition eine Verrastung des Photovoltaik-Moduls 3 sowohl in horizontaler Richtung entlang der Fläche der Glasscheibe, beziehungsweise entlang der Vorder- oder Rückseite, als auch senkrecht dazu bewirkt wird, so dass eine vollständige Arretierung des Photovoltaik-Moduls 3 in allen Richtungen erzielt wird.

Die horizontale Verschiebung des Photovoltaik-Moduls 3 zur Arretierung kann in besonders vorteilhafter Weise auch als Diebstahlschutz-Einrichtung verwendet werden. Die Modulmontage durch horizontales Ineinanderschieben von Modul zu Unterkonstruktion erlaubt eine vereinfachte Diebstahlsicherung des gesamten Modulfeldes. Da bei nebeneinander montierten Kunststoff-Trägern der enge Spalt zwischen den Photovoltaik-Modulen 3 ein Verschieben eines einzelnen Moduls des Modulfeldes nicht erlaubt, wenn der benötigte Weg zur Entriegelung des Photovoltaik-Moduls 3 länger ist, als die Spaltbreite zwischen den Photovoltaik-Modulen, reicht es aus die jeweils äußeren Module mit einer irgendwie gearteten Diebstahlsicherung zu versehen.

Bei heute gängigen Auf-Dach- bzw. In-Dach-Systemen muss demgegenüber jedes einzelne Modul mit einer Diebstahlsicherung versehen werden.

In Weiterbildung der Erfindung ist daher vorgesehen, dass die Breite des Photovoltaik-Moduls in Verrastungsrichtung 38 gemessen größer ist, als die Breite des Kunststoff-Trägers 1 in dieser Richtung abzüglich des Verschiebewegs zwischen der Anfangsposition und der Verrastungsposition. Damit wird erzielt, dass bei der Montage mehrerer Module auf den Kunststoff-Trägern der Spalt zwischen den Photovoltaik-Modulen 3 geringer ist, als der Verschiebeweg.

Es ist dem Fachmann ersichtlich, dass die Erfindung nicht auf die speziellen Ausführungsbeispiele, wie sie in den Figuren dargestellt sind, beschränkt ist. Insbesondere können die einzelnen Merkmale der Ausführungsbeispiele auch im Rahmen der nachstehenden Patentansprüche kombiniert und variiert werden. Beispielsweise können die einzelnen Rastmittel, wie sie an den Modulträgern 33 und dem Kunststoff-Träger 1 vorgesehen sind, auch ausgetauscht werden. Um ein weiteres Beispiel zu nennen, kann auch die Orientierung der Haken 37 umgedreht werden, so dass die Sperrflächen 370 zur Mitte des Modulträgers 33 weisen.

### Bezugszeichenliste:

- 1: Kunststoff-Träger
- 3: Photovoltaik-Modul
- 10: Regenwasser-Abführelement
- 11: Umrandung des Kunststoff-Trägers
- 12: Erhöhung
- 14: Oberseite von 1
- 16: Öffnung
- 18: Montagepunkt von 1
- 20, 22: Rastelemente von 1
- 30: Vorderseite von 3
- 31: Rückseite von 3
- 32: Glasscheibe
- 33: Modulhalter
- 35: Rastelement
- 37: Rastelement, Haken von 3
- 38: Verrastungsrichtung
- 39: Handgriff
- 100: Sicke
- 101: Kabelkanal
- 103: Anlagekante
- 105: Abstellfläche
- 107: Grundebene von 1
- 110: Kante des Kunststoff-Trägers 1
- 111: Querkante des Kunststoff-Trägers 1
- 120: Rand von 12
- 121: Hochsicke
- 122: Ausformung
- 180: Befestigungsschraube
- 181: Feder
- 300: Kante von 3
- 310: Anschlusskabel
- 312: Anschlussdose
- 330: Klebefläche
- 350: Arretierungsfläche von 35
- 370: Sperrfläche von 37
- 371: Führungsfläche von 37
- 372: Blattfederarm

## Patentansprüche

1. Kunststoff-Träger (1) für ein Photovoltaik-Modul (3) in Gestalt eines einteiligen ausgeformten Kunststoffelements mit rechteckigem oder quadratischem Umriss, welches entlang einer Kante (110) des Kunststoff-Trägers (1) verlaufende, langgestreckte Regenwasser-Abführelemente (10) aufweist, welche bei Schrägstellung des Kunststoff-Trägers (1) mit Gefälle entlang dieser lateralen Richtung Regenwasser in Richtung des Gefälles leiten, **dadurch gekennzeichnet, daß** der Kunststoff-Träger (1) weiterhin eine Ausformung in Gestalt einer Erhöhung (12) auf der Oberseite (14) aufweist, deren Rand (120) in einem Abstand zur Umrandung (11) des Kunststoff-Trägers (1) verläuft, und wobei auf der Erhöhung (12) Montagepunkte (18) angeordnet sind, um Befestigungsmittel durch den Kunststoff-Träger (1) hindurch zu führen und an einer Unterkonstruktion zu befestigen, und wobei der Kunststoffträger (1) weiterhin Rastelemente (20, 22) zur rastenden Fixierung eines Photovoltaik-Moduls (3) aufweist.

2. Kunststoff-Träger (1) gemäß dem vorstehenden Anspruch, **dadurch gekennzeichnet, dass** die Erhöhung (12) die Gestalt einer Hochsicke (121) hat, welche eine Öffnung (16) umrahmt.

3. Kunststoff-Träger (1) gemäß einem der beiden vorstehenden Ansprüche, **gekennzeichnet durch** beiderseitig der Erhöhung (12) am Rand angeordnete Sicken 100 als Regenwasser-Abführelemente (10), wobei die Ober- und Unterseiten der Sicken 100 komplementär geformt sind, so dass sich zwei Kunststoff-Träger (1) seitlich versetzt mit ineinandergreifenden Sicken (100) aufeinandersetzen lassen.

4. Kunststoff-Träger (1) gemäß einem der vorstehenden Ansprüche, **dadurch gekennzeichnet, dass** der Kunststoff-Träger (1) aus einer thermoplastischen Formmasse gefertigt ist.

5. Kunststoff-Träger (1) gemäß vorstehendem Anspruch, **dadurch gekennzeichnet, dass** die thermoplastische Formmasse auf Polyamid mit einer Viskositätszahl von 50 bis 250, vorzugsweise 70 bis 200 und besonders bevorzugt 80 bis 150 ml/g, bestimmt gemäß ISO 307 EN an einer 0,5 gew.%-igen Lösung des Polyamids in 96 gew.-%iger Schwefelsäure bei 25 °C basiert.

6. Kunststoff-Träger (1) gemäß einem der vorstehenden Ansprüche, **dadurch gekennzeichnet, dass** die thermoplastische Formasse 0 bis 70 Gewichtsprozent, bevorzugt 10 bis 60 Gewichtsprozent, besonders bevorzugt 20 bis 50 Gewichtsprozent faserförmige oder teilchenförmige Füllstoffe enthält.

7. Kunststoff-Träger (1) gemäß einem der vorstehenden Ansprüche, **dadurch gekennzeichnet, dass** die thermoplastische Formmasse Pigmente und/oder Stabilisatoren zur Verbesserung der Witterungsbeständigkeit und oder der Brandeigenschaften enthält.

8. Kunststoff-Träger (1) gemäß einem der vorstehenden Ansprüche, **dadurch gekennzeichnet, dass** der Kunststoff-Träger (1) stapelbar ausgebildet ist, wobei dessen Ober- und Unterseite zumindest teilweise komplementär sind, so dass beim Aufeinandersetzen eines Kunststoff-Trägers (1) mit dessen Unterseite mit fluchtenden Kanten auf die Oberseite eines weiteren Kunststoff-Trägers (1) die Gesamthöhe der so aufeinandergestapelten beiden Kunststoff-Träger (1) geringer ist als die doppelte Höhe eines einzelnen Kunststoff-Trägers (1).

9. Kunststoff-Träger (1) gemäß einem der vorstehenden Ansprüche, **dadurch gekennzeichnet, dass** der Kunststoff-Träger (1) Rastelemente (20) zur Arretierung in Richtung senkrecht zur Oberseite des Kunststoff-Trägers 1 aufweist, welche in einem Abstand von höchstens einem Sechstel, vorzugsweise von höchstens einem Zehntel der längsten Seitenabmessung des Kunststoff-Trägers (1) vom nächstliegenden Montagepunkt (18) entfernt angeordnet sind.

10. Kunststoff-Träger (1) gemäß einem der vorstehenden Ansprüche, **gekennzeichnet durch** zumindest ein Kabelführungselement, vorzugsweise in Gestalt eines halboffenen Kabelkanals (101), welches oberhalb einer Grundebene (107) des Kunststoff-Trägers 1 verläuft.

11. Verfahren zur Herstellung eines Kunststoffträgers (1) gemäß einem der vorstehenden Ansprüche, **dadurch gekennzeichnet, dass** der Kunststoffträger (1) im Spritzguß- oder Spritzprägeprozess hergestellt wird und zur Verteilung der Schmelze ein Heißkanalsystem mit mehreren Heißkanaldüsen verwendet wird.

12. Photovoltaik-Modul (3), insbesondere ausgebildet zur Fixierung auf einem Kunststoff-Träger (1) gemäß einem der vorstehenden Ansprüche, **dadurch gekennzeichnet, daß** das Photovoltaik-Modul (3) vorzugsweise rahmenlos ist und zumindest eine die photovoltaisch aktive Schicht abdeckende Glasscheibe aufweist, welche die Vorderseite (30) des Photovoltaik-Moduls (3) bildet, wobei auf der der Vorderseite (30) gegenüberliegenden Rückseite (31) des Photovoltaik-Moduls (3) Modulträger (33) aufgeklebt sind, und wobei die Modulträger (33) jeweils zwei Rastelemente an gegenüberliegenden Enden des Modulträgers (33) aufweisen, welche federnd beweglich ausgebildet sind, und wobei diese Rastelemente jeweils Sperrflächen (370) aufweisen, die eine parallel zur Fläche der Glasscheibe liegende Komponente der Flächennormalen aufweisen, so dass durch Anlage dieser Sperrflächen (370) an feststehenden Elementen eine Arretierung in Richtung parallel zur Fläche der Glassscheibe (32) bewirkbar ist, und wobei die Modulträger (33) weitere Rastelemente (35) mit Arretierungsflächen (350) aufweisen, die eine Komponente der Flächennormalen parallel zur Richtung der Flächennormalen der Vorderseite (30) oder Rückseite (31) haben, um in Kontakt mit einem Rastelement einer Halterung eine Bewegung in Richtung dieser Flächennormalen zu blockieren.

13. Photovoltaik-Modul (3) gemäß dem vorstehenden Anspruch, **gekennzeichnet durch** als Handgriffe (39) ausgebildete Modulträger (33).

14. Photovoltaik-Installationssystem mit einem Kunststoffträger (1) und einem Photovoltaik-Modul (3), insbesondere gemäß einem der vorstehenden Ansprüche, **gekennzeichnet durch** Rastelemente (20, 22, 35, 37) an Kunststoff-Träger 1 und Photovoltaik-Modul (3), mit welchen die Arretierung des Photovoltaik-Moduls (3) auf dem Kunststoff-Träger (1) **durch** Auflegen des Photovoltaik-Moduls (3) in einer Anfangsposition und lateralen Verschiebung des Photovoltaik-Moduls 3 auf dem Kunststoff-Träger (1) bis in eine Verrastungsposition eine Verrastung des Photovoltaik-Moduls (3) sowohl in horizontaler Richtung entlang der Vorder- oder Rückseite des Photovoltaik-Moduls (3), als auch senkrecht dazu, und damit eine vollständige Arretierung des Photovoltaik-Moduls (3) in allen Richtungen bewirkbar ist.

15. Photovoltaik-Installationssystem gemäß vorstehendem Anspruch, **dadurch gekennzeichnet, dass** der Kunststoff-Träger (1) eine Abstellfläche (105) und eine an die Abstellfläche angrenzende Anlagekante (103) aufweist, die so positioniert sind, dass das Photovoltaik-Modul (3) bei Anlage an der Anlagekante (103) und Ablage auf der Abstellfläche (105) in einer definierten Anfangsposition für die laterale Verschiebung des Photovoltaik-Moduls (3) entlang des Kunststoff-Trägers (1) zur gegenseitigen Verrastung der Rastelemente (20, 22, 35, 37) von Kunststoff-Träger (1) und Photovoltaik-Modul (3) zu liegen kommt.

16. Photovoltaik-Installationssystem gemäß einem der beiden vorstehenden Ansprüche, **dadurch gekennzeichnet, dass** die Breite des Photovoltaik-Moduls (3) in Verrastungsrichtung (38) gemessen größer ist, als die Breite des Kunststoff-Trägers (1) in dieser Richtung abzüglich des Verschiebewegs zwischen der Anfangsposition und der Verrastungsposition.

## Claims

1. Plastic support (1) for a photovoltaic module (3) in the form of a one-piece moulded plastic element with a rectangular or square outline, which has elongated rainwater discharging elements (10) extending along one edge (110) of the plastic support (1), which, in a tilted position of the plastic support (1) with a gradient, direct rain water along this lateral direction in the direction of the gradient, **characterised in that** the plastic support (1) further comprises a moulding in the form of a raised portion (12) at the upper side (14), with an edge (120) thereof extending at a spaced interval with respect to the border (11) of the plastic support (1), and wherein mounting points (18) are provided on the raised portion (12) for passing fastening means through the plastic support (1) and for fastening them to a substructure, and wherein the plastic support (1) further comprises detent members (20, 22) for snap-fixing a photovoltaic module (3).

2. Plastic support (1) as claimed in the preceding claim, **characterised in that** the raised portion (12) is provided in the form of a raised bead (121) which frames an opening (16).

3. Plastic support (1) as claimed in any one of the two preceding claims, **characterised by** beads (100) as rainwater discharging elements (10) which are arranged on both sides of the raised portion (12) on the edge, wherein the upper and lower sides of the beads (100) are shaped complementary to one another so that two plastic supports (1) can be placed in laterally offset relationship one upon the other with inter-engaging beads (100).

4. Plastic support (1) as claimed in any one of the preceding claims, **characterised in that** the plastic support (1) is made of a thermoplastic moulding compound.

5. Plastic support (1) as claimed in the preceding claim, **characterised in that** the thermoplastic moulding compound is based on polyamide having a viscosity number from 50 to 250, preferably 70 to 200, and particularly preferably 80 to 150 ml/g, as determined according to ISO 307 EN on a 0.5 wt.% solution of the polyamide in 96 wt.% sulphuric acid at 25°C.

6. Plastic support (1) as claimed in any one of the preceding claims, **characterised in that** the thermoplastic moulding compound comprises 0 to 70 percent by weight, preferably 10 to 60 percent by weight, particularly preferably 20 to 50 percent by weight of fibrous or particulate fillers.

7. Plastic support (1) as claimed in any one of the preceding claims, **characterised in that** the thermoplastic moulding compound comprises pigments and/or stabilisers to improve the weather resistance and/or fire properties.

8. Plastic support (1) as claimed in any one of the preceding claims, **characterised in that** the plastic support (1) is configured to be stackable, wherein the upper side and lower side thereof are shaped at least partially complementary to one another, so that when one plastic support (1) is placed with its lower side onto the upper side of another plastic support (1) with the edges aligned, the total height of the thus stacked two plastic supports (1) is less than twice the height of a single plastic support (1).

9. Plastic support (1) as claimed in any one of the preceding claims, **characterised in that** the plastic support (1) comprises detent members (20) for locking in the direction perpendicular to the upper side of the plastic support (1), which are spaced from the closest mounting point (18) by not more than one sixth, preferably not more than one tenth of the longest lateral dimension of the plastic support (1).

10. Plastic support (1) as claimed in any one of the preceding claims, **characterised by** at least one cable guide element, preferably in the form of a half-open cable channel (101) which extends above a base plane (107) of the plastic support (1).

11. Method for producing a plastic support (1) as claimed in any one of the preceding claims, **characterised in that** the plastic support (1) is produced in an injection moulding or injection compression moulding process, and a hot runner system with a plurality of hot runner nozzles is used for distributing the melt.

12. Photovoltaic module (3), in particular formed for fixing on a plastic support (1) as claimed in any one of the preceding claims, **characterised in that** the photovoltaic module (3) is preferably frameless and comprises at least one glass sheet covering the photovoltaically active layer, said glass sheet forming the front side (30) of the photovoltaic module (3), wherein module supports (33) are adhered to the rear side (31) of the photovoltaic module (3) opposite the front side (30), and wherein each of the module supports (33) has two resiliently movable detent members at opposite ends of the module support (33), and wherein each of these detent members has locking surfaces (370) with a component of the surface normal in parallel with the surface of the glass sheet, so that by engaging these locking surfaces (370) at fixed elements, locking can be effected in the direction in parallel with the surface of the glass sheet (32), and wherein the module supports (33) have further detent members (35) with locking surfaces (350) which have a component of the surface normal in parallel with the direction of the surface normal of the front side (30) or rear side (31) to block a movement in the direction of this surface normal when in contact with a detent member of a support.

13. Photovoltaic module (3) as claimed in the preceding claim, **characterised by** module supports (33) formed as handles (39).

14. Photovoltaic installation system with a plastic support (1) and a photovoltaic module (3), in particular as claimed in any one of the preceding claims, **characterised by** detent members (20, 22, 35, 37) at the plastic support (1) and photovoltaic module (3), by means of which locking/latching of the photovoltaic module (3) on the plastic support (1) can be effected both in the horizontal direction along the front side or rear side of the photovoltaic module (3) and also perpendicular thereto, by placing the photovoltaic module (3) in a starting position and laterally displacing the photovoltaic module (3) on the plastic support (1) into a latching position, and so that complete locking of the photovoltaic module (3) in all directions can be effected.

15. Photovoltaic installation system as claimed in the preceding claim, **characterised in that** the plastic support (1) has a stop surface (105) and a support edge (103) adjacent the stop surface, which are positioned such that when the photovoltaic module (3) is engaged at the support edge (103) and placed on the stop surface (105) it comes to rest in a defined starting position for the lateral displacement of the photovoltaic module (3) along the plastic support (1) for mutually latching the detent members (20, 22, 35, 37) of the plastic support (1) and of the photovoltaic module (3).

16. Photovoltaic installation system as claimed in any one of the two preceding claims, **characterised in that** the width of the photovoltaic module (3) measured in the latching direction (38) is greater than the width of the plastic support (1) in this direction minus the displacement path between the starting position and the latching position.

## Revendications

1. Support en matériau synthétique (1) pour un module photovoltaïque (3) sous la forme d'un élément en matériau synthétique en une seule pièce avec un contour rectangulaire ou carré, lequel présente des éléments d'évacuation des eaux de pluie (10) allongés, qui s'étendent le long d'un bord (110) du support en matériau synthétique (1) et qui en position inclinée du support en matériau synthétique (1) avec une pente le long de cette direction latérale guident les eaux de pluie dans le sens de la pente, **caractérisé en ce que** ledit support en matériau synthétique (1) présente en outre un moulage sous la forme d'un relief (12) sur la face supérieure (14), dont la bordure (120) s'étend à intervalle du contour (11) du support en matériau synthétique (1), **en ce que** des points de montage (18) sont disposés sur le relief (12) pour faire passer des moyens de fixation au travers du support en matériau synthétique (1) et les fixer à une sous-construction, et **en ce que** ledit support en matériau synthétique (1) présente en outre des éléments d'enclenchement (20, 22) pour la fixation par enclenchement d'un module photovoltaïque (3).

2. Support en matériau synthétique (1) selon la revendication précédente, **caractérisé en ce que** le relief (12) a la forme d'une nervure (121) encadrant une ouverture (16).

3. Support en matériau synthétique (1) selon une des deux revendications précédentes, **caractérisé par** des moulures (100) disposées contre la bordure de part et d'autre du relief (12) en tant qu'éléments d'évacuation des eaux de pluie (10), les faces supérieures et inférieures des moulures (100) étant de forme complémentaire, si bien que deux supports en matériau synthétique (1) peuvent être superposés en étant latéralement décalés au moyen de moulures (100) s'emboîtant l'une dans l'autre.

4. Support en matériau synthétique (1) selon l'une des revendications précédentes, **caractérisé en ce que** ledit support en matériau synthétique (1) est fabriqué à partir d'une résine thermoplastique.

5. Support en matériau synthétique (1) selon la revendication précédente, **caractérisé en ce que** la résine thermoplastique est à base de polyamide avec un indice de viscosité compris entre 50 et 250, avantageusement entre 70 et 200, et préférentiellement entre 80 et 150 ml/g, déterminé conformément à la norme ISO 307 EN à 25 °C sur une solution à 0,5 % en poids du polyamide dans de l'acide sulfurique à 96 % en poids.

6. Support en matériau synthétique (1) selon l'une des revendications précédentes, **caractérisé en ce que** la résine thermoplastique contient entre 0 et 70 % en poids, avantageusement entre 10 et 60 % en poids, préférentiellement entre 20 et 50 % en poids de matières de charge fibreuses ou particulaires.

7. Support en matériau synthétique (1) selon l'une des revendications précédentes, **caractérisé en ce que** la résine thermoplastique contient des pigments et/ou des stabilisateurs pour améliorer la résistance aux intempéries et ou les propriétés ignifuges.

8. Support en matériau synthétique (1) selon l'une des revendications précédentes, **caractérisé en ce que** ledit support en matériau synthétique (1) est réalisé de manière à être empilable, sa face supérieure et sa face inférieure étant au moins partiellement complémentaires, si bien qu'à la superposition d'un support en matériau synthétique (1) par sa face inférieure sur la face supérieure d'un autre support en matériau synthétique (1), les bords étant alignés, la hauteur totale des deux supports en matériau synthétique (1) ainsi empilés est inférieure au double de la hauteur d'un seul support en matériau synthétiques (1).

9. Support en matériau synthétique (1) selon l'une des revendications précédentes, **caractérisé en ce que** ledit support en matériau synthétique (1) présente des éléments d'enclenchement (20) pour le blocage dans la direction perpendiculaire à la face supérieure du support en matériau synthétique (1), lesquels sont disposés à intervalle d'un sixième au maximum, avantageusement d'un dixième au maximum du côté le plus long du support en matériau synthétique (1) par rapport au point de montage (18) le plus proche.

10. Support en matériau synthétique (1) selon l'une des revendications précédentes, **caractérisé par** au moins un élément de guidage de câble, préférentiellement sous la forme d'un canal de câble (101) semi-ouvert, lequel s'étend au-dessus d'un plan de fond (107) du support en matériau synthétique (1).

11. Procédé de fabrication d'un support en matériau synthétique (1) selon l'une des revendications précédentes, **caractérisé en ce que** ledit support en matériau synthétique (1) est fabriqué par moulage par injection ou moulage par injection-compression et **en ce qu'**un système de canal chaud à plusieurs buses de canal chaud est utilisé pour répartir la fonte.

12. Module photovoltaïque (3), prévu en particulier pour la fixation sur un support en matériau synthétique (1) selon l'une des revendications précédentes, **caractérisé en ce que** ledit module photovoltaïque (3) est préférentiellement exempt de cadre et présente au moins une vitre en verre couvrant la couche photovoltaïquement active qui forme la face avant (30) du module photovoltaïque (3), des supports de module (33) étant collés sur la face arrière (31) opposée à la face avant (30) du module photovoltaïque (3), et les supports de module (33) présentant chacun deux éléments d'enclenchement à des extrémités opposées du support de module (33), lesquels sont réalisés de manière à être élastiquement mobiles, et lesdits éléments d'enclenchement comportant chacun des surfaces de blocage (370) qui présentent une composante de la normale à la surface, parallèle à la surface de la vitre en verre, si bien qu'un blocage dans la direction parallèle à la surface de la vitre en verre (32) peut être obtenu par application desdites surfaces de blocage (370) contre des éléments fixes, et les supports de module (33) présentant d'autres éléments d'enclenchement (35) avec des surfaces de blocage (350) qui présentent une composante de la normale à la surface, parallèle à la direction de la normale à la surface de la face avant (30) ou de la face arrière (31), pour empêcher un déplacement dans la direction de ladite normale à la surface par contact avec un élément d'enclenchement d'un support.

13. Module photovoltaïque (3) selon la revendication précédente, **caractérisé par** des supports de module (33) réalisés comme poignées (39).

14. Système d'installation photovoltaïque avec un support en matériau synthétique (1) et un module photovoltaïque (3), en particulier selon l'une des revendications précédentes, **caractérisé par** des éléments d'enclenchement (20, 22, 35, 37) sur le support en matériau synthétique (1) et le module photovoltaïque (3), permettant la fixation du module photovoltaïque (3) sur le support en matériau synthétique (1) par pose du module photovoltaïque (3) dans une position initiale et déplacement latéral du module photovoltaïque (3) sur le support en matériau synthétique (1) jusqu'à une position d'enclenchement du module photovoltaïque (3) tant en direction horizontale le long de la face avant ou de la face arrière du module photovoltaïque (3) que perpendiculairement à celle-ci, et ainsi un blocage total du module photovoltaïque (3) dans toutes les directions.

15. Système d'installation photovoltaïque selon la revendication précédente, **caractérisé en ce que** ledit support en matériau synthétique (1) présente une surface de contact (105) et un bord de butée (103) adjacent à la surface de contact, agencés de telle manière que le module photovoltaïque (3) arrive dans une position initiale définie pour le déplacement latéral du module photovoltaïque (3) le long du support en matériau synthétiques (1) pour l'enclenchement réciproque des éléments d'enclenchement (20, 22, 35, 37) du support en matériau synthétique (1) et du module photovoltaïque (3), par application contre le bord de butée (103) et pose sur la surface de contact (105).

16. Système d'installation photovoltaïque selon l'une des deux revendications précédentes, **caractérisé en ce que** la largeur du module photovoltaïque (3) mesurée dans la direction d'enclenchement (38) est supérieure à la largeur du support en matériau synthétique (1) dans cette direction, déduction faite de la course de déplacement entre la position initiale et la position d'enclenchement.
